# EUROPEAN PATENT SPECIFICATION

(11) **EP 4 595 079 B1**
(45) Date of publication and mention of the grant of the patent: **15.07.2026**
(21) Application number: 23785882.4
(22) Date of filing: 29.09.2023
(51) Int. Cl.: G21C 3/07, C23C 14/28, C23C 14/08, C23C 14/58

(54) **COATINGS WITH ENVIRONMENTAL BARRIER BASED ON HIGH-TEMPERATURE STABLE AMORPHOUS OXIDES**
BESCHICHTUNGEN MIT UMGEBUNGSBARRIERE AUF BASIS VON HOCHTEMPERATURSTABILEN AMORPHEN OXIDEN
REVÊTEMENTS AVEC BARRIÈRE ENVIRONNEMENTALE À BASE D'OXYDES AMORPHES STABLES À HAUTE TEMPÉRATURE

(30) Priority: 30.09.2022 IT 202200020112
(43) Date of publication of application: 06.08.2025
(73) Proprietor: Fondazione Istituto Italiano di Tecnologia, 16163 Genova (IT); Politecnico di Milano, 20133 Milano (IT)
(72) Inventor: DI FONZO, Fabio, 20136 Milano (IT); CABRIOLI, Mattia, 27029 Vigevano (IT); VANAZZI, Matteo, 16163 Genova (IT); PALADINO, Boris, 21013 Gallarate (VA) (IT); LOIACONO, Davide, 20134 Milano (IT)
(74) Representative: Vanzini, Christian
(86) International application number: PCT/IB2023/059745
(87) International publication number: WO 2024/069553

(56) References cited:
- VARGHESE PAULSON ET AL: "Degradation of thermally sprayed Al2O3 coatings in reactor-grade liquid-sodium and its mitigation by laser treatment", CERAMICS INTERNATIONAL, ELSEVIER, AMSTERDAM, NL, vol. 48, no. 10, 2 February 2022 (2022-02-02), pages 13914 - 13926, XP087016098, ISSN: 0272-8842, [retrieved on 20220202], DOI: 10.1016/J.CERAMINT.2022.01.276
- PENG DOU ET AL: "Preliminary study on nano- and micro-composite solgel based alumina coatings on structural components of leadbismuth eutectic cooled fast breeder reactors", JOURNAL OF NUCLEAR MATERIALS, ELSEVIER B.V, NETHERLANDS, vol. 409, no. 3, 10 November 2010 (2010-11-10), pages 177 - 182, XP028361606, ISSN: 0022-3115, [retrieved on 20101116], DOI: 10.1016/J.JNUCMAT.2010.11.022

## Description

The present invention relates generally to materials used in high-temperature non-aqueous environments, such as in industrial processes and energy conversion technologies.

### Background of the invention

In modern and future energy conversion technologies and industrial processes, high-temperature non-aqueous environments are becoming of great interest for increasing energy conversion efficiency and enabling new manufacturing processes.

The first and most important example are fourth-generation nuclear reactor technologies, which promise wide availability of safe and CO₂-free energy. Several concepts involve the use of liquid metals (LM), heavy liquid metals (HLM), molten salt (MS) or He as a heat carrier to extract the heat generated in the reactor core from fast fission and fusion reactions. Lead-Cooled Fast Reactors (LFRs), accelerator-driven systems (ADSs) and fusion reactor designs involve cooling by LM such as lithium or sodium, HLM such as lead, lead-bismuth eutectic (LBE) and lead-lithium eutectic (LLE). Despite the attractive properties of LM coolants, liquid metal corrosion (LMC) drastically alters the microstructure and chemical composition of metal alloy-based structural components, resulting in deterioration of mechanical properties and ultimately increasing the risk of failure.

The requirements for application in the aforesaid nuclear systems are met by austenitic and ferritic/martensitic steels. However, these alloys are unable to resist selective dissolution by LM and HLM and are subject to liquid metal embrittlement (LME). In addition to nuclear applications, LM, HLM and molten salts are being studied as working fluids in many heat management applications and high-temperature energy conversion devices such as concentrating solar power plants. In these applications, mitigation strategies designed to protect steel from corrosion include the formation of surface alloys and protective coatings. Metal or metal alloy coatings should be pre-oxidized or should form a protective layer of oxide in situ. However, poor reliability and poor control of the oxidation process pose additional risks to the implementation of these technologies. Among the proposed ceramic coatings, only amorphous aluminum oxide coatings, a-Al₂O₃, deposited on stainless steel substrates by pulsed laser deposition (PLD) have been shown to provide protection of the underlying metal from corrosion by LM and HLM and by permeation of hydrogen isotopes, while also exhibiting radiation tolerance and minimal discrepancy with the substrate in terms of mechanical properties. In particular, although many oxide compounds are stable to reduction by liquid lead, only a-Al₂O₃ has thermomechanical properties compatible with those of stainless steel.

As described in US 2014241485 A1, the outstanding properties of a-Al₂O₃ coatings are closely related to their integrity. Said integrity is in turn related to the stability of the microstructure of the coating. All the examples reported in US 2014241485 A1 of a-Al₂O₃-coated steels in HLM were executed at temperatures at or below 600°C. Above this temperature, a strong crystallization may induce cracking in the film due to the increase in density from the amorphous phase (ρ≈3.5 g/cm³) to the crystalline phase (3.5 g/cm³<p<4 g/cm³), thus exposing the underlying support to corrosive environments. Stabilization and control of amorphous-crystalline phase transitions under the combined effects of radiation fields and high temperature are of primary importance for the final application. A nuclear reactor or other similar thermal system may in fact have transients that exceed the nominal operating temperature by as much as a few hundred degrees for limited periods of time.

Other relevant prior art documents are XP087016098 and XP028361606.

Further, the effect of the radiation field should be considered. In particular, radiation-enhanced crystallization and radiation-induced crystallization are destabilization mechanisms that influence the crystallization temperature, or promote the nucleation of specific crystalline phases, in a material under irradiation with respect to that which might be observed in a purely thermal regime. As a result, the temperature thresholds for amorphous-crystalline and phase-to-phase transitions could shift rigidly toward lower values.

In conclusion, the microstructure of the coating affects the mechanical properties of the film, while phase transitions may lead to densification processes, crack formation and loss of adhesion and coating integrity. Therefore, fine-tuning and controlling the properties of the coating by stabilizing its microstructure would enable the advancement and development of advanced nuclear systems and other high-temperature technologies that make use of non-aqueous working fluids.

### Summary of the invention

For the objects indicated above, the subject of the invention is a metallic component for high-temperature non-aqueous environments, comprising a body of metallic material and a protective coating applied to an outer surface of the body of metallic material, intended in use to contact a non-aqueous working fluid,
wherein said protective coating includes at least one layer of amorphous aluminum oxide, said at least one layer of amorphous aluminum oxide comprising at least one doping element uniformly dispersed in the layer of amorphous aluminum oxide, said at least one doping element being selected from the group consisting of C, Na, K, Cs, Mg, Ca, Sr, P, Si, Fe, Y, Zr, Mo, W, La, Ce, Er, Yb.

For the purposes of this invention, "high temperature" means a temperature above 600°C.

In the event in which the metal component is steel, particularly austenitic steel or ferritic-martensitic steel, it is possible to obtain an aluminum oxide-based coating, composed of an amorphous material, with thermomechanical properties (i.e., Poisson's coefficient, elastic modulus, and coefficient of thermal expansion) compatible with those of austenitic and ferritic-martensitic stainless steels. Further, the coating has greater hardness than stainless steel. As a result, it may withstand the substrate deformation expected for normal operation of stainless steel components and prevents wear damage to said metal components.

The coating of the present invention is resistant to crystallization and crack formation at high temperatures, at least up to 900°C.

By virtue of a matrix composed of aluminum oxide, the coating presented here is resistant to corrosive attack by liquid metal (LM), heavy liquid metal (HLM) or molten salt (MS).

Therefore it is an efficient barrier to prevent corrosion of the stainless steel to which the coating is applied.

Further, the homogeneous and amorphous coating is thus an effective barrier against the permeation of hydrogen isotopes by preventing hydrogen isotope infiltration within the coated stainless steel and subsequent embrittlement.

In conclusion, the coating disclosed here is resistant to radiation and may withstand high doses without losing its protective properties.

The stabilization of the amorphous phase of aluminum oxide at high temperatures is desirable for application in many technological fields where resistance to wear, corrosion and irradiation is required. In particular, in the field of liquid-metal-cooled fast fission reactors, the increased resistance to crystallization allows for the application of aluminum oxide coatings on structural steel coatings. The qualified performance of aluminum oxide coatings in this field is thus extended to temperatures above the operating condition (600°C). The first consequence is increased radiation tolerance at currently established operating temperatures. Further, a delay in the amorphous-crystalline transition allows for the operating temperature setpoint to be increased according to the design and to ensure higher power generation efficiency.

### Detailed description of the invention

Further features and advantages of the invention will become clearer from the following detailed description of an embodiment of the invention, made with reference to the accompanying drawings, provided purely for illustrative and non-limiting purposes, in which
Fig. 1 represents the phase diagram of the pseudo-binary system Al₂O₃-Y₂O₃, adapted from Fabrichnayan et al, Assessment of thermodynamic parameters in the system ZrO2-Y2O3-Al2O₃, Zeitschrift für Metallkunde, 95, 2004;
Fig. 2 is a graph showing X-ray diffraction patterns of a pure Al₂O₃ film and doped Al₂O₃ films of the Example, after the deposition process;
Fig. 3 is a graph showing X-ray diffraction (XRD) patterns of the pure Al₂O₃ film and the doped Al₂O₃ films of the Example, after annealing at 700°C for 72h;
Fig. 4 is a graph showing X-ray diffraction patterns of the pure Al₂O₃ film and the doped Al₂O₃ films of the Example, after annealing at 800°C for 72h;
Fig. 5 is a graph showing X-ray diffraction patterns of the pure Al₂O₃ film and the doped Al₂O₃ films of the Example, after annealing at 900°C for 72h;
Fig. 6 shows scanning electron microscope (SEM) images at lower magnification (left) and higher magnification (right) of the pure Al₂O₃ film after annealing at 700°C for 72h;
Fig. 7 shows scanning electron microscope (SEM) images at lower magnification (first row) and higher magnification (second row) of the pure Al₂O₃ film and the doped Al₂O₃ films of the Example, after annealing at 800°C for 72h;
Fig. 8 shows scanning electron microscope (SEM) images at lower magnification (first row) and higher magnification (second row) of the pure Al₂O₃ film and the doped Al₂O₃ films of the Example, after annealing at 900°C for 72h.

An Al₂O₃-based coating is now described. The coating consists of an amorphous, homogeneous layer with thicknesses from 10 nm to 100 µm, preferably 0.1 to 10 µm, with a crystalline domain fraction of less than 1% by volume and in any case undetectable by XRD.

The composition of the coating disclosed here is characterized by an atomic dispersion of one or more dopants, uniformly distributed in an Al₂O₃ matrix. This dispersion of dopants has the effect of delaying the onset of the crystallization of the coating material. Further, once the crystallization threshold is reached, the dopants that are distributed in the coating material have the secondary effect of delaying the grain growth of the first metastable crystalline phase of Al₂O₃, namely γ-Al₂O₃, to higher temperatures than a pure Al₂O₃ coating. The advantage in this case is that γ-Al₂O₃ has a similar density to a-Al₂O₃, and therefore mechanical stresses are minimized upon its formation.

The dopants considered for stabilization of the amorphous matrix are selected from the group comprising C, Na, K, Cs, Mg, Ca, Sr, P, Si, Fe, Y, Zr, Mo, W, La, Ce, Er, Yb. The dopants may be added in the form of pure elements or in the form of the relevant most stable oxide compound. Further, the dopants could be added as a single-element dopant or multi-element dopant.

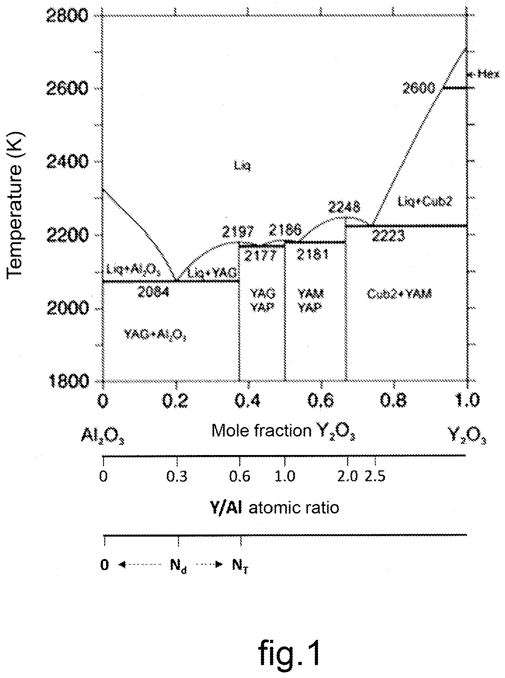

In the first case, the single-element dopant is introduced into the Al₂O₃ matrix in the form of the pure element or in the form of the relevant stable oxide, in a concentration that is specified as follows, with reference to Fig. 1. Given the pseudo-binary phase diagram of the Al₂O₃-oxide doping system, the first ternary compound existing in the phase diagram and containing the highest molar concentration of Al₂O₃, C_{T}, is identified. For the composition of the aforesaid ternary compound, the number N_{T} is defined as the atomic ratio of doping atoms to Al atoms. The coating material described here has a doping oxide concentration C_{d} for which the condition 0<N_{d}≤N_{T} is met, thus disclosing an atomic ratio of doping atoms to Al atoms that is less than the atomic ratio N_{T} of the aforesaid ternary compound characterized by the molar concentration C_{T}. In an embodiment of the same invention, the condition is limited to 0.001*N_{T}≤N_{d}≤0.90*N_{T}. In a preferred embodiment, the condition is further limited to 0.01*N_{T}≤N_{d}≤0.70*N_{T}.

In an embodiment of the invention (shown in Fig. 1), the single-element dopant would be yttrium (C_{T}=37.5% mol, corresponding to a weight concentration of 57.1% wt) and the concentration C_{d} of Y₂O₃ selected in the range of 0.1-25% mol, corresponding to weight concentrations in the range of 0.3-43.0% wt, more precisely in the range of 11-22% mol, corresponding to weight concentrations in the range of 22-38% wt, still more precisely in the range of 15-20% mol, corresponding to weight concentrations in the range of 28-35% wt. Hereinafter, for simplicity, reference will be made to concentrations expressed in % mol.

The phase diagram in Fig. 1 for the pseudo-binary Al₂O₃-Y₂O₃ system clarifies the correspondence between the mole fraction of the doping oxide and the doping atomic ratio on Al. In particular, N_{T} is the atomic ratio Y/Al that characterizes yttrium-aluminum garnet (YAG), while N_{d} is calculated from the selected molar concentration of Y₂O₃ and is within the range specified above.

The inventors thus found that the addition of the doping element in amorphous aluminum oxide allows the coating to be stabilized at temperatures above 600°C. The molar concentration range within which stable amorphous aluminum oxide occurs tends to narrow as the temperatures to which the coating is subjected increase. For example, in the case in which yttrium is used as a dopant for a coating applied on steel, the inventors have found that at temperatures below 800°C the amorphous aluminum oxide coating is stable for any value of the doping oxide concentration that is less than or equal to C_{T}=37.5% mol. At temperatures between 800°C and 900°C, coatings having a doping oxide concentration between 11% mol and 22% mol are stable.

Preliminary experiments have shown that it is possible to increase the temperature of stability above 900°C by adding one or more additional dopants (always chosen from the elements listed above). In such a situation, there would be a first doping element, the concentration of which is defined in the same way as the case relating to the single dopant discussed above. Additional dopants would be added in such quantities as to have a molar concentration, for each dopant, less than or equal to that of the oxide of the first doping element.

For the specific case of oxides forming a solid solution with Al₂O₃, such as ZrO₂, the doping oxide concentration is selected in the range 0.1%mol≤C_{d}≤50% mol.

The coating structure described above is composed of at least one layer of the Al₂O₃-based material described above, however, it may also comprise a plurality of layers, each characterized by the same or a different chemical composition and microstructure. The thickness of each layer is between 10 nm and 100 µm, preferably in the range of 500 nm to 5 µm. For example, in one embodiment of the disclosed invention, the coating would comprise a single layer with a thickness of 3 µm.

The combination of amorphous structure and chemical composition based on an Al₂O₃ matrix gives several properties to the above-described coating material, namely wear resistance, mechanical compatibility with stainless steel, barrier to the permeation of the hydrogen isotopes, protection from LM, HLM and MS corrosion, radiation and crystallization resistance.

The coating may be applied to multiple support materials, characterized by different geometries. Preferably, the coating applies to stainless steels of austenitic type (e.g., AISI 316/316L, 15-15 Ti) and ferritic/martensitic type (for example, reduced activation ferritic martensitic EUROFER). For example, the substrate could be a tube, in particular the cladding tube of the fuel for LM- or HLM- or MS-cooled nuclear reactors.

The growth of the coating may be obtained by vapor-phase techniques for thin-film deposition. For example, the coating is applied to the substrate material by pulsed laser deposition (PLD). Another example of a deposition technique is atomic layer deposition (ALD). In one embodiment of the present invention, the coating is applied with a deposition technique that does not make use of support heating, but rather limits the temperature of the components to be coated to the range going from room temperature to a few hundred degrees Celsius.

The crystallization temperature of the Al₂O₃-based coatings described above is at least 100°C higher than that of pure Al₂O₃ coatings. Further, as shown by preliminary investigations, when the temperature exceeds the threshold temperature for crystallization, the composition of Al₂O₃-based coatings would allow the nucleation of nanometer-sized crystalline domains of γ-Al2O3, thus demonstrating the coating's ability to induce a delaying effect on the amorphous-crystalline transition and control the nucleated crystalline phase within the coating material.

Further, the chemical composition of the coating is such that it prevents the nucleation of ternary compounds and second phases at high temperatures. As designers of new LFR and solar thermal systems are striving to achieve higher system efficiency, it is necessary to raise the coolant temperature above 650°C. Considering the safety margins for the operation and the effect of irradiation that could induce or accelerate crystallization, it is reasonable to assume that the coating should withstand temperatures up to 800°C.

The coating material described above is able to withstand even more extreme conditions, by virtue of its composition and microstructure, and resist crystallization and mechanical failure at least up to 900°C.

The integrity of the coating, in particular, is of paramount importance for the protection of stainless steel from LM and HLM corrosion in nuclear reactors, as the generation of defects (loss of adhesion, bubble formation, crack formation) would expose the substrate and increase corrosion damage to the structural components of the reactor.

### Example

An example of an application of the invention to LFR stainless steel cladding is now presented. AISI 316/316L tubes (outer diameter 10 mm, length 200 mm) were first polished and then coated with 3-µm-thick layers of Al₂O₃, pure and doped with an atomic dispersion of Y, obtained by ablation of a mixed target with Y₂O₃ doping concentration of 5, 10 16 and 23% mol in Al₂O₃, respectively. Segments 20 mm long were cut from each tube. These samples were subjected to heat treatment in a vacuum furnace for 72 hours at temperatures of 700, 800 and 900°C. The measured value for total pressure during the dwell time at the setpoint temperature was 10⁻³ Pa: under these conditions, a small amount of oxygen is still present in the furnace and reacts rapidly with the steel substrates to form iron and chromium oxides on the uncoated surfaces
of the tube segments (edges and uncoated inner surface) and on the outer surface where defects in the coating expose the substrate to the environment of the furnace.

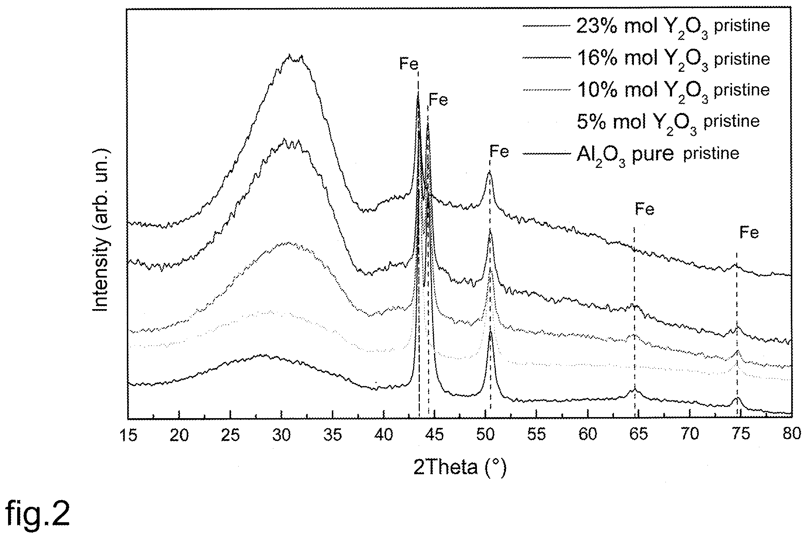

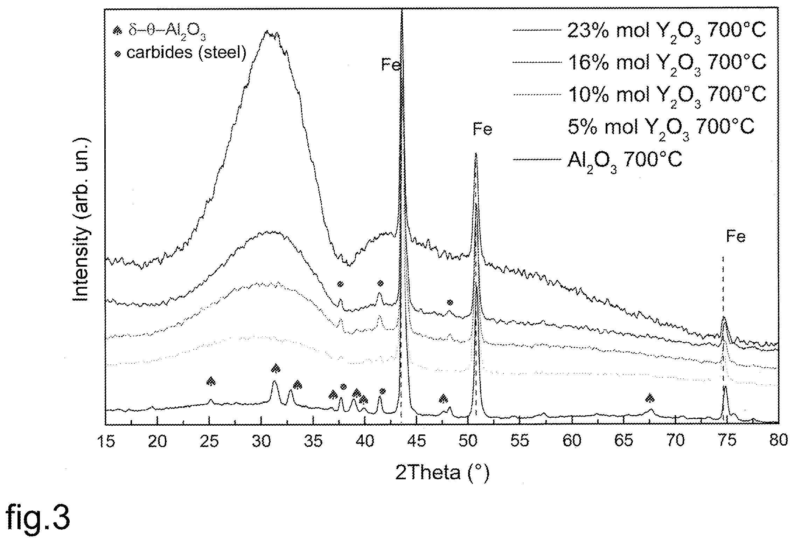

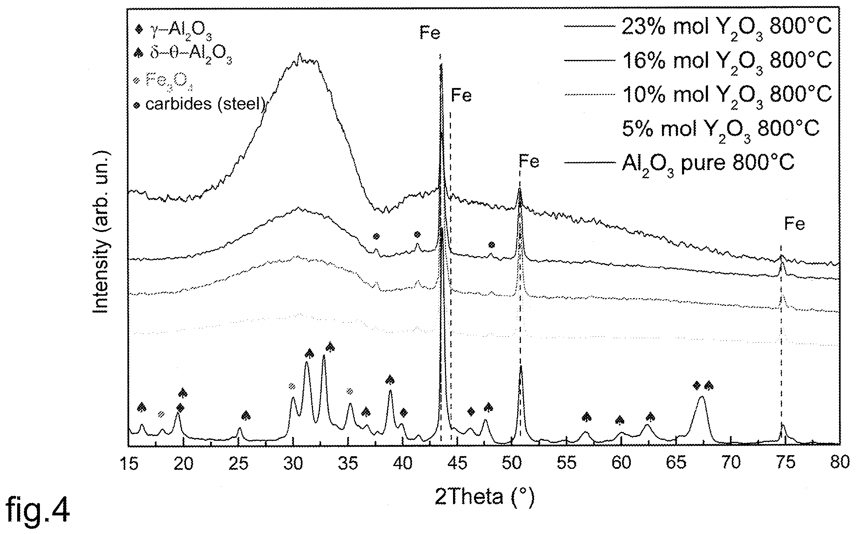

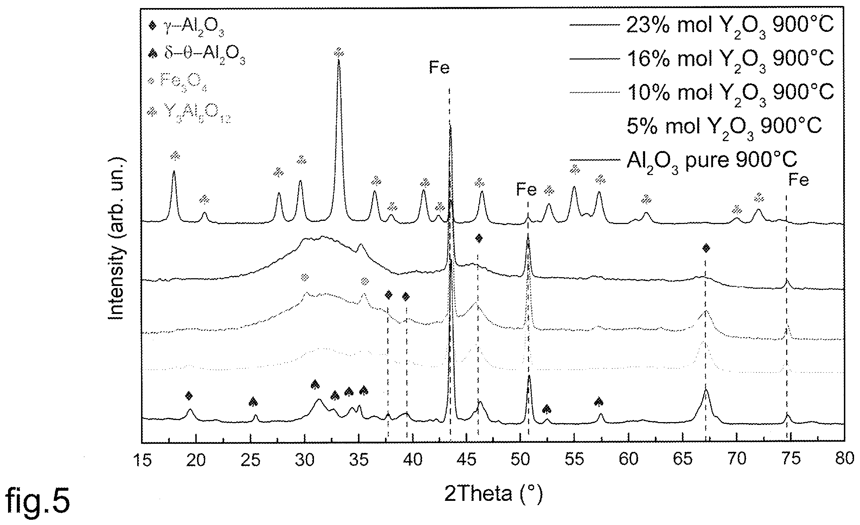

The XRD patterns shown in Fig. 2-5 describe the evolution of the coatings from the amorphous phase to the crystalline phase and eventual nucleation of ternary compounds (i.e., yttrium garnet and aluminum garnet-YAG). The onset of crystallization for pure Al₂O₃ is detected for temperatures around 700°C, so XRD data for annealed samples are reported for temperatures of 800 and 900°C. Pure Al₂O₃ is well crystallized as early as 800°C, while the most significant delaying effect is confirmed for a doping concentration of 23% mol, for which only the presence of γ-Al2O3 is detected by XRD. Most of the reflections from the cubic γ-Al2O3 phase are missing, and the large peaks detected suggest that the material is in the early stages of crystallization.

It is worth noting that with 23% mol of doping oxide, the film crystallizes rapidly in the YAG phase for the sample annealed at 900°C.

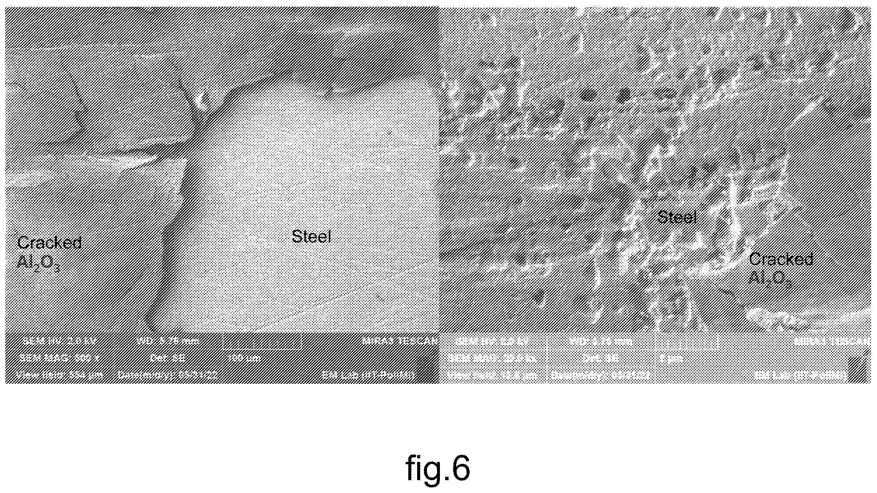

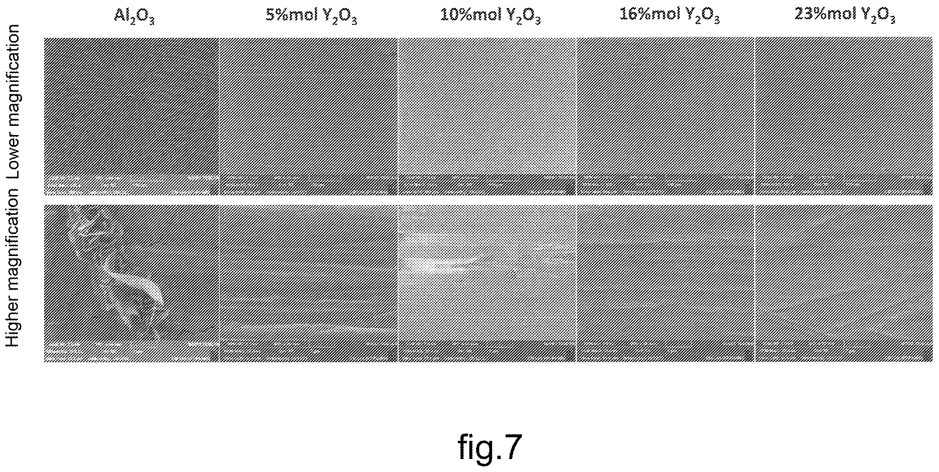

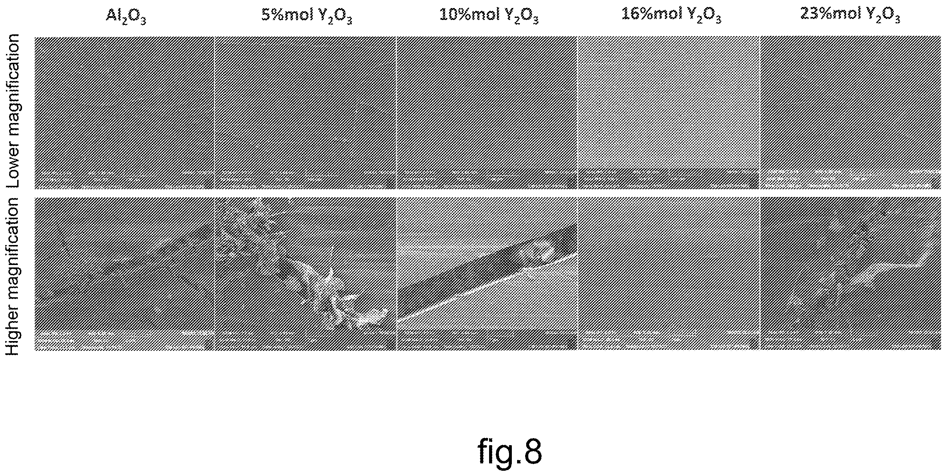

The top SEM views shown in Fig. 6 through 8 demonstrate the inability of the pure Al₂O₃ film to provide a compact protective barrier to the steel support, as evidenced by the formation of cracks and the growth of iron oxides therethrough. The crack formation is also detected for Al₂O₃ coatings doped at 5, 10 and 23% mol at 900°C. The densification process caused by the nucleation and growth of γ-Al₂O₃ crystalline and YAG phases induces the rupture of the coating and allows for the oxidation of the substrate. Only the sample with 16% mol dopant was found intact and adhered to the underlying steel.

## Claims

1. Metallic component for high-temperature non-aqueous environments, comprising a body of metallic material and a protective coating applied to an outer surface of the body of metallic material, intended in use to contact a non-aqueous working fluid,
wherein said protective coating includes at least one layer of amorphous aluminum oxide,
**characterised by** at least one layer of amorphous aluminum oxide comprising at least one doping element uniformly dispersed in the layer of amorphous aluminum oxide, said at least one doping element being selected from the group consisting of C, Na, K, Cs, Mg, Ca, Sr, P, Si, Fe, Y, Zr, Mo, W, La, Ce, Er, Yb.

2. Metallic component according to claim 1, comprising a single doping element selected from the group consisting of C, Na, K, Cs, Mg, Ca, Sr, P, Si, Fe, Y, Zr, Mo, W, La, Ce, Er, Yb,
wherein the doping element is capable of forming a ternary compound with aluminum oxide, and the atomic ratio N_{d} between the doping element and aluminum is such that 0<N_{d}≤N_{T}, where N_{T} is the value of the atomic ratio N_{d} corresponding to a maximum mole fraction C_{T}, defined as the mole fraction of the oxide of the doping element in the ternary compound containing the highest mole fraction of aluminum oxide in the phase diagram aluminum oxide-oxide of the doping element, or
wherein the oxide of the doping element forms a solid solution with aluminum oxide, and the mole fraction C_{d} of the oxide of the doping element in the binary system aluminum oxide-oxide of the doping element is such that 0.1%mol<C_{d}≤50%mol.

3. Metallic component according to claim 1, comprising a plurality of doping elements selected from the group consisting of C, Na, K, Cs, Mg, Ca, Sr, P, Si, Fe, Y, Zr, Mo, W, La, Ce, Er, Yb, said plurality of doping elements comprising a first doping element and at least one second doping element,
wherein the first doping element is capable of forming a ternary compound with aluminum oxide, and the atomic ratio N_{d} between the first doping element and aluminum is such that 0<N_{d}≤N_{T}, where N_{T} is the value of the atomic ratio N_{d} corresponding to a maximum mole fraction C_{T}, defined as the mole fraction of the oxide of the first doping element in the ternary compound containing the highest mole fraction of aluminum oxide in the phase diagram aluminum oxide-oxide of the first doping element, or
wherein the oxide of the first doping element forms a solid solution with aluminum oxide, and the mole fraction C_{d} of the oxide of the first doping element in the binary system aluminum oxide-oxide of the first doping element is such that 0.1%mol≤C_{d}≤50%mol,
and wherein the mole fraction of the relevant oxide of each second doping element is lower than or equal to the mole fraction C_{d} of the oxide of the first doping element.

4. Metallic component according to claim 2 or 3, wherein the atomic ratio N_{d} between the oxide of the single doping element and aluminum, or between the oxide of the first doping element and aluminum, is such that 0.001*N_{T}≤N_{d}≤0.90*N_{T}, and preferably such that 0.01*N_{T}≤N_{d}≤0.70*N_{T}.

5. Metallic component according to any of claims from 2 to 4, wherein the single doping element, or the first doping element, is yttrium, and wherein the mole fraction C_{d} of yttrium oxide is comprised in the range 0.1-25% mol, and preferably in the range 11-22% mol, more preferably in the range 15-20%.

6. Metallic component according to any of the preceding claims, wherein said metallic material is steel.

7. Metallic component according to claim 6, wherein said steel is selected from the group consisting of ferritic-martensitic steels and austenitic steels.

8. Metallic component according to any of the preceding claims, wherein said metallic component is a cladding tube for nuclear fuel for a liquid metal or molten salt cooled reactor.

## Patentansprüche

1. Metallische Komponente für nichtwässrige Hochtemperaturumgebungen, umfassend einen Körper aus metallischem Material und eine Schutzbeschichtung, die auf einer äußeren Oberfläche des Körpers aus metallischem Material aufgebracht ist und im Gebrauch dazu bestimmt ist, mit einem nichtwässrigen Arbeitsfluid in Kontakt zu treten,
wobei die Schutzbeschichtung mindestens eine Schicht aus amorphem Aluminiumoxid umfasst,
**dadurch gekennzeichnet, dass**
die mindestens eine Schicht aus amorphem Aluminiumoxid mindestens ein Dotierungselement umfasst, das gleichmäßig in der Schicht aus amorphem Aluminiumoxid dispergiert ist, wobei das mindestens eine Dotierungselement aus der Gruppe ausgewählt ist, bestehend aus C, Na, K, Cs, Mg, Ca, Sr, P, Si, Fe, Y, Zr, Mo, W, La, Ce, Er, Yb.

2. Metallische Komponente nach Anspruch 1, umfassend ein einzelnes Dotierungselement, ausgewählt aus der Gruppe bestehend aus C, Na, K, Cs, Mg, Ca, Sr, P, Si, Fe, Y, Zr, Mo, W, La, Ce, Er, Yb,
wobei das Dotierungselement dazu geeignet ist, eine ternäre Verbindung mit Aluminiumoxid zu bilden, und das Atomverhältnis Nd zwischen dem Dotierungselement und Aluminium derart ist, dass 0<Nd≤NT gilt, wobei NT der Wert des Atomverhältnisses Nd ist, der einer maximalen Molfraktion CT entspricht, definiert als die Molfraktion des Oxids des Dotierungselements in der ternären Verbindung, die die höchste Molfraktion an Aluminiumoxid im Phasendiagramm Aluminiumoxid-Oxid des Dotierungselements enthält,
oder
wobei das Oxid des Dotierungselements eine feste Lösung mit Aluminiumoxid bildet und die Molfraktion Cd des Oxids des Dotierungselements im binären System Aluminiumoxid-Oxid des Dotierungselements derart ist, dass 0,1 %mol<Cd≤50 %mol.

3. Metallische Komponente nach Anspruch 1, umfassend eine Mehrzahl von Dotierungselementen, ausgewählt aus der Gruppe bestehend aus C, Na, K, Cs, Mg, Ca, Sr, P, Si, Fe, Y, Zr, Mo, W, La, Ce, Er, Yb, wobei die Mehrzahl von Dotierungselementen ein erstes Dotierungselement und mindestens ein zweites Dotierungselement umfasst,
wobei das erste Dotierungselement dazu geeignet ist, eine ternäre Verbindung mit Aluminiumoxid zu bilden, und das Atomverhältnis Nd zwischen dem ersten Dotierungselement und Aluminium derart ist, dass 0<Nd≤NT gilt, wobei NT der Wert des Atomverhältnisses Nd ist, der einer maximalen Molfraktion CT entspricht, definiert als die Molfraktion des Oxids des ersten Dotierungselements in der ternären Verbindung, die die höchste Molfraktion an Aluminiumoxid im Phasendiagramm Aluminiumoxid-Oxid des ersten Dotierungselements enthält,
oder
wobei das Oxid des ersten Dotierungselements eine feste Lösung mit Aluminiumoxid bildet und die Molfraktion Cd des Oxids des ersten Dotierungselements im binären System Aluminiumoxid-Oxid des ersten Dotierungselements derart ist, dass 0,1 %mol≤Cd≤50 %mol,
und wobei die Molfraktion des entsprechenden Oxids jedes zweiten Dotierungselements kleiner oder gleich der Molfraktion Cd des Oxids des ersten Dotierungselements ist.

4. Metallische Komponente nach Anspruch 2 oder 3, wobei das Atomverhältnis Nd zwischen dem Oxid des einzelnen Dotierungselements und Aluminium oder zwischen dem Oxid des ersten Dotierungselements und Aluminium derart ist, dass 0,001NT≤Nd≤0,90NT gilt, und bevorzugt derart, dass 0,01NT≤Nd≤0,70NT gilt.

5. Metallische Komponente nach einem der Ansprüche 2 bis 4, wobei das einzelne Dotierungselement oder das erste Dotierungselement Yttrium ist und wobei die Molfraktion Cd von Yttriumoxid im Bereich von 0,1-25 %mol liegt und bevorzugt im Bereich von 11-22 %mol, stärker bevorzugt im Bereich von 15-20 %.

6. Metallische Komponente nach einem der vorhergehenden Ansprüche, wobei das metallische Material Stahl ist.

7. Metallische Komponente nach Anspruch 6, wobei der Stahl aus der Gruppe bestehend aus ferritisch-martensitischen Stählen und austenitischen Stählen ausgewählt ist.

8. Metallische Komponente nach einem der vorhergehenden Ansprüche, wobei die metallische Komponente ein Hüllrohr für Kernbrennstoff für einen mit Flüssigmetall oder geschmolzenem Salz gekühlten Reaktor ist.

## Revendications

1. Composant métallique pour environnements non aqueux à haute température, comprenant un corps en matériau métallique et un revêtement protecteur appliqué sur une surface extérieure du corps en matériau métallique, destiné, en utilisation, à entrer en contact avec un fluide de travail non aqueux,
dans lequel ledit revêtement protecteur comprend au moins une couche d'oxyde d'aluminium amorphe,
**caractérisé en ce que**
ladite au moins une couche d'oxyde d'aluminium amorphe comprend au moins un élément de dopage uniformément dispersé dans la couche d'oxyde d'aluminium amorphe, ledit au moins un élément de dopage étant sélectionné dans le groupe consistant en C, Na, K, Cs, Mg, Ca, Sr, P, Si, Fe, Y, Zr, Mo, W, La, Ce, Er, Yb.

2. Composant métallique selon la revendication 1, comprenant un seul élément de dopage sélectionné dans le groupe consistant en C, Na, K, Cs, Mg, Ca, Sr, P, Si, Fe, Y, Zr, Mo, W, La, Ce, Er, Yb,
dans lequel l'élément de dopage est capable de former un composé ternaire avec l'oxyde d'aluminium, et le rapport atomique Nd entre l'élément de dopage et l'aluminium est tel que 0<Nd≤NT, où NT est la valeur du rapport atomique Nd correspondant à une fraction molaire maximale CT, définie comme la fraction molaire de l'oxyde de l'élément de dopage dans le composé ternaire contenant la plus haute fraction molaire d'oxyde d'aluminium dans le diagramme de phases oxyde d'aluminium-oxyde de l'élément de dopage,
ou
dans lequel l'oxyde de l'élément de dopage forme une solution solide avec l'oxyde d'aluminium, et la fraction molaire Cd de l'oxyde de l'élément de dopage dans le système binaire oxyde d'aluminium-oxyde de l'élément de dopage est telle que 0,1 %mol<Cd≤50 %mol.

3. Composant métallique selon la revendication 1, comprenant une pluralité d'éléments de dopage sélectionnés dans le groupe consistant en C, Na, K, Cs, Mg, Ca, Sr, P, Si, Fe, Y, Zr, Mo, W, La, Ce, Er, Yb, ladite pluralité d'éléments de dopage comprenant un premier élément de dopage et au moins un second élément de dopage,
dans lequel le premier élément de dopage est capable de former un composé ternaire avec l'oxyde d'aluminium, et le rapport atomique Nd entre le premier élément de dopage et l'aluminium est tel que 0<Nd≤NT, où NT est la valeur du rapport atomique Nd correspondant à une fraction molaire maximale CT, définie comme la fraction molaire de l'oxyde du premier élément de dopage dans le composé ternaire contenant la plus haute fraction molaire d'oxyde d'aluminium dans le diagramme de phases oxyde d'aluminium-oxyde du premier élément de dopage,
ou
dans lequel l'oxyde du premier élément de dopage forme une solution solide avec l'oxyde d'aluminium, et la fraction molaire Cd de l'oxyde du premier élément de dopage dans le système binaire oxyde d'aluminium-oxyde du premier élément de dopage est telle que 0,1 %mol≤Cd≤50 %mol,
et dans lequel la fraction molaire de l'oxyde correspondant de chaque second élément de dopage est inférieure ou égale à la fraction molaire Cd de l'oxyde du premier élément de dopage.

4. Composant métallique selon la revendication 2 ou 3, dans lequel le rapport atomique Nd entre l'oxyde du seul élément de dopage et l'aluminium, ou entre l'oxyde du premier élément de dopage et l'aluminium, est tel que 0,001NT≤Nd≤0,90NT, et de préférence tel que 0,01NT≤Nd≤0,70NT.

5. Composant métallique selon l'une quelconque des revendications 2 à 4, dans lequel le seul élément de dopage, ou le premier élément de dopage, est l'yttrium, et dans lequel la fraction molaire Cd de l'oxyde d'yttrium est comprise dans la plage de 0,1-25 %mol, et de préférence dans la plage de 11-22 %mol, plus préférablement dans la plage de 15-20 %.

6. Composant métallique selon l'une quelconque des revendications précédentes, dans lequel ledit matériau métallique est de l'acier.

7. Composant métallique selon la revendication 6, dans lequel ledit acier est sélectionné dans le groupe consistant en les aciers ferritiques-martensitiques et les aciers austénitiques.

8. Composant métallique selon l'une quelconque des revendications précédentes, dans lequel ledit composant métallique est un tube de gainage pour combustible nucléaire destiné à un réacteur refroidi par métal liquide ou sels fondus.
